(19) **Europäisches Patentamt / European Patent Office / Office européen des brevets**

(11) **EP 4 703 815 A1**

(12) **EUROPEAN PATENT APPLICATION**

(43) Date of publication:
**04.03.2026 Bulletin 2026/10**

(21) Application number: **25155896.1**

(22) Date of filing: **04.02.2025**

(51) International Patent Classification (IPC):
**G05B 17/02** (2006.01)    **G06F 30/27** (2020.01)
**G06N 3/126** (2023.01)    **G06Q 50/06** (2024.01)
**H02J 3/00** (2026.01)

(52) Cooperative Patent Classification (CPC):
**H02J 3/0012; G05B 17/02; G06F 30/27;
G06N 3/006; G06N 3/086; G06N 3/126; G06N 5/01;
G06N 7/01; G06N 20/00; G06N 20/10; G06N 20/20;
G06Q 50/06;** H02J 2103/30

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **30.08.2024 PT 2024119668**

(71) Applicants:
• **INESC TEC - Instituto de Engenharia de Sistemas e
Computadores, Tecnologia e Ciência
4200-465 Porto (PT)**

• **Universidade Do Porto
4099-002 Porto (PT)**

(72) Inventors:
• **PEÇAS LOPES, JOÃO ABEL
4200-465 PORTO (PT)**
• **GOMES DE SOUSA BENTO BESSA, RICARDO JORGE
4200-465 PORTO (PT)**
• **DE SOUSA FERNANDES, FRANCISCO
4200-465 PORTO (PT)**

(74) Representative: **Patentree
Edificio Net
Rua de Salazares, 842
4149-002 Porto (PT)**

(54) **METHOD FOR DYNAMIC SECURITY ASSESSMENT OF STABILITY OF A POWER SYSTEM AND SYSTEM THEREOF**

(57) The present document discloses a computer-implemented method and system for providing a dynamic security assessment of stability of a power system comprising: receiving input data comprising an operational data record comprising OP-characterizing variables of the power system OP; applying the model to the OP-characterizing variables to obtain a stability classification. It is also disclosed a computer program product and a system configured to carry out the method herein disclosed.

**Fig. 3**

## Description

### TECHNICAL FIELD

The present disclosure relates to a computer implemented method and system for providing a dynamic security assessment of stability of a power system, i.e. a power system comprising one or more generating sources, and connecting transmission and distribution facilities, operated to supply electric energy.

### BACKGROUND

The large-scale integration of renewable energy sources (RES) is leading the power system towards operating conditions characterized by low inertia, high temporal variability of generation, and an increasing number of distributed energy resources (DER). In control rooms, this change will drastically increase the supervision and control needs of human operators [1], hindering their task of ensuring a secure and reliable operation.

Dynamic Security Assessment (DSA) is a process used in power systems to evaluate the stability, and security of the electrical grid in real-time or near-real-time. Unlike traditional static security assessment, which evaluates the grid's security under steady-state conditions, DSA considers the grid's behaviour under varying conditions, for sudden disturbances or changes in load, generation, or system topology.

The online Dynamic Security Assessment (DSA) task perfectly illustrates how integrating RES can increase complexity. Security categorisation becomes more complex as the system is more prone to instability and has more interacting elements of the DER type, whose behaviour depends on the primary source (e.g., wind, solar) and control methodology (grid-following and grid-forming variants). The number of scenarios that must be evaluated online increases due to the variability and uncertainty of RES. This increased complexity and the widespread presence of power electronics leads to large and complex state models that turn online DSA into a problem too large to be solved using model-based techniques.

Despite advances in high-performance computing, resorting to time-domain simulation in model-based approaches makes the process computationally very demanding, in particular for an online task.

Data-driven techniques have long been seen as promising solutions [2], as they can instantly diagnose the system condition for multiple operation scenarios with reasonable accuracy. Such advantage has, however, been shadowed by the "black-box" nature of many artificial intelligence (AI) techniques that instil algorithmic aversion in human operators. This calls for the development of inherently interpretable AI models that humans can easily understand and integrate with their domain knowledge. Particularly, in the case of isolated power systems, these tools have a high potential as human operators frequently look for understandable and secure ways of operating the system that are easy to validate and do not demand an extension of the existing domain knowledge.

Among the first endeavours of AI in the power systems industry are the expert systems (ES) [3], an inference engine (programming logic) that uses a combination of expert-defined rules and factual knowledge to make deductions about the system state and decisions. Despite ES's strong presence at the early stages of the DSA [4], it became evident that this approach could pose challenges due to its inability to ensure near-optimal performance, lack of leverage on available data, and the demanding nature of deriving a large number of rules through arduous reasoning. Knowledge-based systems were combined with data-driven methods to address the inherent challenges of conventional ES. At first, such combinations used techniques such as decision trees (DT) [5] or fuzzy inference systems (FIS) to derive the ES's rules. Later, this experience culminated in the creation of hybrid ES that included data-driven techniques or some of its characteristics inside of the ES [6].

Despite the aforementioned efforts, approaches mainly led by Artificial Neural Network (ANN) and DT grew popular. ANNs were first used within the DSA context in [7] and, since then, the classical multi-layer perceptrons have evolved into more complex structures, such as convolutional neural networks [8], graph neural networks [9], and other deep learning-based architectures [10]. The classifier/regressor training paradigm has also undergone different changes, from supervised to semisupervised learning that augments the training set with the addition of other unlabelled samples [11]. The security categorisation enabled by ANNs has often been integrated into preventive control modules that promote the generator rescheduling/dispatch, either by iteratively comparing the dispatch output with the regressor security quantification [12] or by including ANN-extracted sensitivity factors in the optimisation method [13]. While ANNs exhibit high generalisation capabilities, their interpretability poses inherent challenges for human operators during the learning and operational phases [14], which can result in algorithm aversion.

Contrarily to an ANN, a DT is inherently interpretable since the space partition performed to achieve a classification or regression task can be easily transformed into "if-then" rules. Among the widely adopted DT algorithms in DSA, ID3 [15] and CART [16] stand out. Two other algorithms worth mentioning are the random forest [17], which addresses the overfitting problem of conventional DT algorithms, and the optimal classification tree [18], in which the problem of obtaining local rather than global optimal DTs is addressed by forming the entire DT in a single step. Regardless of the algorithm, DTs node splitting criteria are based on linear inequalities of the data-set attributes (e.g., "X1 < k1", "X1 < k1 & X2 < k2", "X1 + X2 < k12"), which means that the attribute search space can only be linearly partitioned.

In that sense, more complex "real-world" attribute relations that non-linear inequations may represent (e.g., X1/X2 < k12 or sin(X1/X2) < k12) will not be modelled in the DT, only linearly approximated, which is a limitation. These DT's rules have been used to find preventive actions either via their inclusion as constraints of the re-dispatch optimisation [19] or by providing indicators on the most effective control variables [15], [16]. Similar to ANNs, these rules have also served as a way to iteratively verify the security of a re-scheduled solution [20]. Still, in complex problems, the number of decision rules can grow fairly quickly [21], challenging the human ability to understand the overall model functioning (e.g., key features, governing laws), which is a characteristic known as global interpretability [22]. Thus, strategies like tree pruning [21], multi-objective DT model selection [23] or penalty functions related to the tree complexity [24] are commonly adopted to limit the tree depth, leading to a complex trade-off between accuracy and interpretability [18].

Other data-driven approaches applied to DSA are support vector machines, k-nearest neighbours, and Bayesian regression. For a comprehensive review, see [10].

Many of the reviewed AI-based approaches, due to the extended model size and complexity, hinder humans from fully understanding the model's capabilities and limitations and developing an accurate mental model of AI. As a result, risk-averse human operators may have restricted confidence in these approaches. Recent advances in explainable AI (XAI), such as SHapley Additive exPlanations (SHAP) [25]. These "explanations" generally correspond to feature or layer-wise importance factors for a set of specific model outputs. On a different path, and to provide a dimension of interpretability, methods that derive interpretable proxy models, such as trees or rule-based models from "black-box" models, have also been proposed [26]. XAI techniques still have different "challenges" [14], especially in the case of high-stakes decision problems such as the DSA, namely: a) the "explanations" may not consistently align with the computations of the original model, which may result in the operator's misunderstanding of the model behaviour; b) the XAI algorithm is an additional model to be debugged in the development phase, which is not error-free. Therefore, adhering to an inherently interpretable model is preferable, as discussed in [14]. Such models, characterized by their representations and compact nature, enable a straightforward grasp of their internal dynamics, ensuring interpretability and the ability to offer articulate explanations.

These technical difficulties are aggravated for power systems which are inherently less stable by nature, such as the Madeira Island's power system, as a result of being an isolated grid, with low inertia also as a result of high shares of renewable energy converter-based generation. This requires continuous system security monitoring, making the online DSA function fundamental. Moreover, the presence of diverse DER, such as RES power plants with different capabilities (e.g., fault ride through - FRT, participation in frequency control) and BESS that can operate in different control modes (grid-forming - GFM, grid following - GFL), results in very different response to disturbances that makes the online DSA a challenging task.

These facts are disclosed in order to illustrate the technical problem addressed by the present disclosure.

## GENERAL DESCRIPTION

In a high-risk sector like power systems, transparency and interpretability are key principles for effectively deploying artificial intelligence (AI) in power system control rooms. Therefore, this herein it is proposed a method, also named as ESM, for generating highly interpretable data-driven models for dynamic security assessment (DSA), namely in online security classification and the definition of preventive actions.

IEC defines an electric power system (IEV ref. 692-01-02) as comprising one or more generating sources, and connecting transmission and distribution facilities, operated to supply electric energy. That is, an electric power system includes all installations and plant, within defined bounds, provided for the purpose of generating, transmitting and distributing electric energy.

Power system stability may be defined as the ability of an electric power system, for a given initial operating condition, to regain a state of operating equilibrium after being subjected to a physical disturbance, with most system variables bounded so that practically the entire system remains intact. IEC also defines power system stability (IEV ref. 603-03-01) as the capability of a power system to regain a steady state, characterized by the synchronous operation of the generators after a disturbance due, for example, to variation of power or impedance.

Power system security may be defined as the capability of a power system using its existing resources to maintain reliable power supplies in the face of unexpected shocks and sudden disruptions in real time, such as the unanticipated loss of key generation or network components, loss of fuel, or rapid changes in demand.

In an embodiment, the disclosed method uses simulated annealing for a data-driven evolution of a model template, enabling different cooperative learning schemes between humans and AI.

The Madeira Island power system was used to validate the application of the disclosed method in DSA. The results show that ESM has classification accuracy comparable to pruned decision trees and higherglobal interpretability and outperforms an operator-defined expert system and an artificial neural network in defining preventive actions.

The present document discloses a computer-implemented method for providing a model for dynamic security assessment of stability of a power system, in particular a method for dynamic security assessment of stability of a power system, comprising: (a) receiving input data comprising a training dataset comprising training data records, each training data record corresponding to an operating point, OP, of an operating scenario of the power network and comprising a set of OP-characterizing variables and a stability classification for the characterized OP; (b) receiving a template model as a current model of the power network stability, wherein a model comprises one or more conditional statements (if), each conditional statement comprising one or more logical expressions (a>2.1), each logical expression comprising one or more logical operators (OR, AND), zero or more numerical constants (2.1), zero or more weighted OP-characterizing variables (a), wherein each conditional statement returns a stability classification of stable or unstable (return 1); (c) setting a temperature variable with an initial temperature from a predetermined cooling scheme; (d) selecting a mutation from a mutation database comprising a plurality of mutations, wherein each mutation comprises a change instruction of addition, removal, or replacement of a logical expression, a logical operator, a logical constant and/or a variable; (e) applying the selected mutation to the current model for obtaining a neighbour model; (f) evaluating a fitness function of the current and neighbour models; (g) if the fitness of the neighbour model is improved relative to the fitness of the current model, or if a random number between 0 and 1 is lower than a probability of adopting the mutation, then update the current model to be the neighbour model; (h) adjust the temperature variable according to the predetermined cooling scheme; repeat steps (c)-(h) until the temperature variable reaches a final temperature from the predetermined cooling scheme.

In an embodiment, the method further comprises a step of outputting the current model as the model for dynamic security assessment of stability of a power system, network.

In an embodiment, the probability is also a function of the temperature variable.

In an embodiment, the probability is also a function of the difference between fitness of the current model and the fitness of the neighbour model.

In an embodiment, the change instruction, and the logical expression, logical operator, logical constant and/or variable to be of added, removed, or replaced, are represented by a binary token, in particular a bytecode token.

In an embodiment, the initial model is a human-predetermined model.

In an embodiment, each repetition of steps (c)-(h) comprises removing variables with zeroed weight in the current model; and/or sum numerical constants in each logical expression.

In an embodiment, the probability is also a function of the temperature variable weighed by a tuneable Boltzmann constant, Kb, and initial, T0, and final, Tf, temperatures of the cooling scheme.

In an embodiment, the steps (c)-(h) are performed in parallel to enhance the speed and efficiency of the dynamic analysis.

It is further disclosed a computer-implemented method for providing a dynamic security assessment of stability of a power system using a model provided by the method for providing model for dynamic security assessment of stability of a power system, comprising: receiving input data comprising an operational data record comprising OP-characterizing variables of the power network OP; applying the model to the OP-characterizing variables to obtain a stability classification.

In an embodiment, the method comprises continuously assessing the stability of the power system by: continuously receiving input data comprising an operational data record comprising OP-characterizing variables of the power network OP; continuously applying the model to the OP-characterizing variables to obtain a stability classification.

In an embodiment, the method comprises generating real-time alerts based on observed network behaviours and emerging threat patterns; and, outputting the generated alerts, in particular comprising triggering automated corrective actions within the power network according to the generated real-time alerts.

It is further disclosed a system comprising a processor configured to carry out the method herein presented.

It is also disclosed a computer program product embodied in a non-transitory computer readable medium and comprising computer instructions which when executed by a computer, cause the computer to carry out the method herein presented.

## BRIEF DESCRIPTION OF THE DRAWINGS

The following figures provide preferred embodiments for illustrating the disclosure and should not be seen as limiting the scope of invention.

**Figure 1:** Schematic representation of an embodiment of an ESM template, with mutable statements in plain lettering and immutable model parts.

**Figure 2:** Schematic representation of an embodiment of a SM evolution process for generating a DSA classifier.

**Figure 3:** Schematic representation of an embodiment of an ESM evolution in supervised and reinforcement learning.

**Figure 4:** Schematic representation of an embodiment of a primitive version of a classifier for Online Dynamic Security Classification.

**Figure 5:** Graphical representation of a performance comparison of between tree, pruned tree and ESM classification methods.

**Figure 6:** Schematic representation of an embodiment of a TMO computation for model $\Theta_0$.

**Figure 7:** Schematic representation of an embodiment of a RMO computation for model $\Theta_0$.

**Figure 8:** Graphical representation of the tree, pruned tree and ESM classification models interpretability.

**Figure 9:** Schematic representation of a transformation of ESM classifier into a regressor.

**Figure 10:** Graphical representation in scatter plots of the values of $S_{Nad}$ and $S_{Reg}$.

**Figure 11:** Schematic representation of an embodiment of a Human-ES agent.

**Figure 12:** Schematic representation of a primitive version of the ESM agent.

**Figure 13:** Graphical representation of the performance of ESM vs. Human-ES and RL-ANN (benchmark models).

**Figure 14:** Schematic representation of a final version of the RL ESM agent.

## DETAILED DESCRIPTION

The present document thus also discloses a computer-implemented method for providing a dynamic security assessment of stability of a power system comprising: receiving input data comprising an operational data record comprising OP-characterizing variables of the power network OP; applying the model to the OP-characterizing variables to obtain a stability classification. It is also disclosed a computer program product and a system configured to carry out the method herein disclosed.

The present document incorporates by reference two previous works. The first work stems from using evolutionary search with a list of 65 basic mathematical operations, referred to as the "operations vocabulary", to automatically discover ML algorithms from scratch with minimal human intervention, as detailed in [27]. In contrast to this document, the present disclosure uses and refines the simulated annealing (SA) algorithm (benefiting from its convergence properties, as detailed in [28]) while introducing the concept of predefined templates to guide the search process.

Briefly, as will be appreciated, systems and methods consistent with this disclosure can be performed by software or firmware in machine readable form on a tangible (e.g., non-transitory) storage medium. For example, the software or firmware can be in the form of a computer program including computer program code adapted to cause the system to perform the monitoring and various actions described herein when the program is run on a computer or suitable hardware device, and where the computer program can be embodied on a computer readable medium. Examples of tangible storage media include computer storage devices having computer-readable media such as disks, thumb drives, flash memory, and the like, and do not include propagated signals. Propagated signals can be present in a tangible storage media. The computer program can be suitable for execution on a parallel processor or a serial processor such that various actions described herein can be carried out in any suitable order, or simultaneously. The code utilized by one or more implementations of the present invention comprise instructions that control the processor to execute methods, such as detailed herein. The instructions can comprise a program, a component, a single module, or a plurality of modules that operate in cooperation with one another. More generally, the code comprises a portion of an implementation implemented as a computer program. The component(s) or module(s) that comprise a computer program implementation can include anything that can be executed by a computer such as, for example, compiled code, binary machine level instructions, assembly code, source level code, scripts, function calls, library routines, and the like. In other implementations, the code can be implemented in firmware or a hardware arrangement.

The second work, which is also incorporated by reference, presents the potential of evolutionary strategies as a method for Reinforcement Learning (RL) without backpropagation. Specifically, black-box optimization, namely evolutionary strategies, is employed to maximise rewards, focusing on tuning the weights and parameters of an ANN policy network [29], instead of using a class of RL algorithms based on the Markov decision process formalism and the concept of value functions. This RL model is used as a benchmark model later. The methodology used by the research described herein also adopts a meta-heuristic optimisation algorithm for adjusting the policy model. However, this work uses an interpretable model, instead of an ANN as a decision agent.

Furthermore, the proposed approach shares similarities with established paradigms in the field of AI, specifically neurosymbolic learning [30] and genetic programming [31]. Nevertheless, neurosymbolic learning methods often rely on demonstrations from a teaching oracle, commonly a pre-trained ANN through RL. These approaches typically use context-free grammars rooted in automata theory as a foundational policy model. Genetic programming differs from the current disclosure by typically employing a less adaptable tree-based representation, introducing higher complexity in human interaction. Finally, the present disclosure brings the following contributions to the DSA state of the art:

[0041]  - A novel Model (ESM), which, unlike ANN-based approaches, has the capability to generate transparent pieces of knowledge, such as statements or rules, thereby ensuring interpretability and facilitating modifications by human experts. In that sense, the method enables the creation of different cooperative learning approaches between humans and AI, either at the start of the algorithm, where the operator can define an initial template grounded on prior system knowledge or physical reasoning or during the evolution process to provide additional guidance to the search algorithm.

[0042]  - Illustrates the capacity of a representation to facilitate seamless model adaptation, thereby enabling the performance of diverse tasks. For instance, the present disclosuredemonstrates the transformation of a security classification problem by manipulating a model classifier into a regressor without the need for any re-training. This unique attribute is called reflection in [32], denoting the model's inherent capability for direct and structured knowledge updates, enhancing its accuracy and comprehensiveness. Notably, achieving such adaptability is significantly more challenging when working with ANN [32].

. Use of RL, following the framework of [29], [33], combined with a model to derive preventive actions in case of system insecurity. In contrast to [26], ESM offers the benefit of not necessitating a "blackbox" oracle to imitate and approximate with a set of interpretable rules.

[0044]  - A model (SM) is an explicit representation of knowledge that combines items such as symbols or special characters, e.g., $a$, 1, +, -, and formal elements ("words", e.g., variable $var_1$) to construct primitives and inference rules and create a framework that facilitates the human interpretation of information within the context of the model.

The basic building blocks used in the Model, the symbols, can be items of a domain-specific language (DSL).

In an embodiment, the method uses symbols and/or keywords (reserved words that have particular meaning to the compiler, e.g., *if, else, return*).

In another embodiment, for example in cases where non-traditional operators are needed to represent knowledge (e.g., in the decision system), a DSL is created as it enables the use of customized building blocks.

Eq. 1 shows a generic example of an SM, $\Theta_0$, designed using symbols and words from the set $S_0 = \{x,y,z,2,6,4,+,\times,=,<,>,and,if,else\}$.

$$\Theta_0 : \begin{cases} if(x < 2 \text{ and } y > 1) : z = x \times 3 \\ else : z = x + 2 \end{cases} \tag{1}$$

When the elements of an SM are mutated using an evolutionary or a stochastic technique so that another SM is created (or evolved) by learning from data, it is referred to as ESM. This evolution (or mutation) of the model $\Theta_0$ to model $\Theta_1$ is illustrated by Eq. 2.

$$\Theta_0 : \begin{cases} if(x < 2 \text{ and } y > 1) : z = x \times 3 \\ else : z = x + 2 \end{cases}$$

$$\Theta_1 : \begin{cases} if(x < 2 \text{ or } y > 1) : z = x \div 3 \\ else : z = x + \mathbf{5.1} \end{cases} \tag{2}$$

The spectrum of SM that an ESM can potentially transform into is constrained by the symbols defined within its domain $S_e$. This domain encompasses all elements found in the *primitive model* $\Theta_0$ and those that can be employed in creating new models. A generic example is:

$$S_E \cup \{V_E, N_E, A_E, C_E, L_E, W_E\}$$

$$V_E = \{a,b,c,d,x,y,z\}, N_E = \{R\}$$

$$A_E = \{+,-,x,\div,=\}, C_E = \{<,>\}$$

$$L_E = \{and,or\}, W_E = \{if,elif,else\} \tag{3}$$

In theory, if considering an infinite number of combinations, an ESM has the potential to embody all possible symbol combinations within its domain $S_E$. However, in practice, the universe of models is constrained by the *primitive model,* the model template, the evolutionary or stochastic technique that is used to guide the evolution, and on the specific mutations under consideration, as described herein.

An important element of the knowledge presentation in ESM is the *primitive model,* encompassing the definition of the model's template (or sketch) and its initialisation. Defining the template includes specifying the architecture and all other parts of the model that are not eligible for mutation, thereby setting clear boundaries for evolution. This precaution prevents unchecked expansion or reduction of the model, ensuring that it remains capable of performing the task.

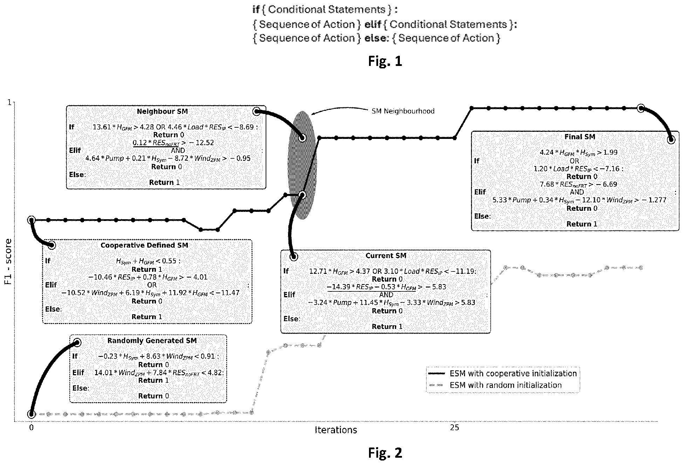

**Figure 1** shows a schematic representation of an embodiment of an ESM template, with mutable statements in plain lettering and immutable model parts (highlighted in bold).

In this embodiment, the mutable components of the SM, such as conditions or actions, are predefined by a human operator, randomly generated by the machine, or collaboratively defined if the operator inputs part of the model and the other part is machine-generated, e.g., randomly generated.

Incorporating the human expert into the initialisation loop leverages the valuable prior knowledge typically held by experts through their interactions with the environment (e.g., the power system) or their grasp of physical reasoning. This prior knowledge enhances the *primitive model* of the SM, providing a more effective starting point for the learning process and often resulting in improved convergence.

In an embodiment, the process of evolving the SM from data, uses both supervised learning and RL settings.

**Figure 2** shows a schematic representation of an embodiment of a SM evolution process for generating a DSA classifier, wherein the value "1" corresponds to secure operation, and the value "0" is unsecure. It is also shown herein three snapshots of the ESM classifier, representing its initial, intermediate, and final states and underlined it is presented the difference between the current and the neighbour model after a SM transformation using a sequence of mutations sampled from a user-defined mutation pool on a copy of the current SM.

This example considers a *primitive model,* which is either randomly generated or cooperatively defined by a human as discussed previously, resulting in distinct initial solutions and evolution patterns.

In an embodiment, a *parent-child* architecture is used to guide the evolution of the SM, wherein SA is the *parent* that manages the evolution of the model's structure by controlling the mutations, while the *child* is differential evolution (DE) algorithm responsible for the tunning of the program's numerical constants.

In an embodiment, the Simulated Annealing (SA) comprises controlling an ESM via its temperature equation and neighbourhood definition, thus enabling an effortless evolution control and removing the need for defining a map between symbols and numeric values (e.g., required in particle swarm optimisation), which is a non-trivial task for large models.

This single-solution nature also allows the operator to easily inspect and/or update the ESM at any point in the evolution without the need to perform any assumption.

In an embodiment, the method's constants are tuned via a differential evolution (DE) which is a simple, effective, and fast method for tuning the program's constants, and displayed superiority in accuracy and computational effort compared to the other methodologies (e.g., SA, Bayesian optimisation).

---

**Algorithm 1** Evolution process of the ESM

---

**Require:** $Kb$, $T_0$, $T_f$
1: Generate a symbolic model, $SM_i$ (II-B).
2: Tune numerical constants of $SM_i$ (DE).
3: **while** $T > T_f$ **do**
4: Generate neighbor symbolic model, $SM_n$ (III-B).
5: Tune numerical constants of $SM_n$ (DE).

6: **if** $\mathcal{F}_i > \mathcal{F}_n$, or $\mathcal{R}(0,1) < e^{\frac{\mathcal{F}_i - \mathcal{F}_n}{T \cdot Kb}}$ **then**
7: $SM_i = SM_n$
8: Adjust $T$ according to cooling scheme
9: Perform simplification on $SM_i$ (III-C).

---

An embodiment of the pseudo-code for the proposed evolution process is presented in Algorithm 1, where $SM_i$ is the current model, $F_i$ is $SM_i's$ fitness to perform the task of interest, $F_n$ is $SM_n$'s fitness to perform the task of interest, $I_T$ is the number of iterations per temperature, $T$ is the temperature of the SA cooling scheme, $Kb$ is the virtual Boltzmann constant, $T_0$ and $T_f$ are the initial and final temperatures of the SA cooling scheme. The foundational characteristics of the SA [28] algorithm remain visible in this model version.

In an embodiment, during a pre-designated cooling scheme (e.g., linear, exponential), a solution passes through different neighbourhood states and changes according to the Metropolis acceptance criterion until its energy reaches a minimum. However, given that the solution is no longer an array of dimension *N* but a sequence of expressions forming an SM, this version has distinct features, particularly regarding neighbourhood definition. Moreover, it introduces an additional phase known as *simplification,* during which the model is inspected and possibly automatically simplified to enhance interpretability.

In an embodiment, in the SA, a solution may transition into neighbouring states, also recognized as candidate states, depending on that state's fitness and the value of a sampled probability (Metropolis acceptance criterion).

In an embodiment, a particle neighbourhood is defined in numerical optimisation by coupling a distance limit with a random number generator $\Re(\cdot)$, e.g., $N(X) = X + 0.1 \cdot \Re(\cdot)$.

In an embodiment, the method further comprises a mutation-based stochastic neighbour generator.

It is also disclosed a mutation-based stochastic neighbour generator, the neighbouring SM is obtained by performing a sequence of mutations sampled from a user-defined mutation pool on a copy of the current SM. To sample the mutations, the value of a uniformly generated random number, $U(0,1)$, is compared with the probability of adopting each mutation *Pa,* being a mutation $m_j$ drawn if the condition of Eq. 4 applies. The mutations used herein and their respective probability of adoption are listed in Table I. They were chosen given their ease of implementation within most environments and their ability to generate new neighbours and not just simply random solutions.

$$\forall j, \ if(U(0,1) < Pa_j) : SM_n = m_j(SM_i)$$
$$+$$
$$\{j \in Z : j \leq N_{Mut}\} \tag{4}$$

As seen in Table I, the mutations with a larger transformation power (e.g., *Addition/Removal of Condition* or *Logical Operator Change*) have a smaller probability of adoption, compared to the ones that perform minor changes on the model syntax (e.g., *Parcel Removal* or *Parcel Mutation*). This enables a frequent generation of neighbours sufficiently close to the current solution, hence ensuring convergence while allowing the sporadic generation of more diverse neighbours in the name of a larger search space exploration. These probabilities can be determined by trial-and-error experiments in a validation set aiming to improve the convergence of the SA algorithm or an optimisation approach of the hyper-parameters can be followed.

TABLE I: Mutation pool used in the neighbour generation.

| Mutation | Pa |
|---|---|
| *Addition/Removal of Condition* <br> *e.g., if(x + y > 1) → if(x + y > 4 **AND** z < 3)* | 1/15 |
| *Logical Operator Change* <br> *e.g., if(x + y > 4 ANDz < 3) → if(x + y > 4 **OR z < 3**)* | 1/10 |
| *Comparison Operator Change* <br> *e.g., if(x + y > 4) → if(x + y < 4)* | 1/5 |
| Addition or Removal of Parcels <br> *e.g., if(x + y > 4) → if(x + y - **z** > 4)* | 1/3 |
| *Parcel Mutation* <br> *e.g., if(x > 4) → if(z > 4) \| if(**x** × **z** > 4) \| if(**x** ÷ **z** > 4)* | 1 |

The decision to resort to a pool of diverse and structured mutations instead of using a single and more generic mutation (e.g., symbol-for-symbol replacement) is justified by the increase in the controllability of the model transformations. On the one hand, this eases the implementation process within most environments, as it avoids syntax errors that would result from the misplacement of the operators (e.g., replacing a logical operator with a number). On the other hand, it allows better management of the diversity between the existing and the candidate model, thus ensuring that these are sufficiently close to be considered neighbours, which is essential for method convergence.

Note that as long as the reasoning regarding the generation of sufficiently close neighbours is kept and a similar scheme is considered for the probability of adoption, the user is free to choose different mutations. Assuming that the established model template and the ESM representation domain are respected, the human expert, i.e. an operator, can directly perform mutations during the learning process, e.g., determining which model parts should mutated.

In an embodiment, the ESM *Parcel Mutation* process uses a mutual information (MI)-based variable neighbourhood. Such neighbourhood is defined at the beginning of the evolution by computing the MI between all domain variables and the classification labels.

In an embodiment, the SM comprises a graphical user interface (GUI) featuring redundant statements with increased size and diminished overall interpretability.

Optionally, a periodic model inspection, denoted as *simplification,* is introduced in the method. The effects that the different SM statements have on the model output are evaluated, automatically removing the ones with no effect and carrying out a classical mathematical inspection of each expression. The considered model template influences this phase (see Fig. 2). The approach followed to simplify the SMs is described in Algorithm 2.

---

**Algorithm 2** *Simplification* process of the ESM

1: **Output based simplification:**
2: for All Statements ($St_i$) **do**
3: Evaluate the effect of $St_i$ on the SM output.
4: **if** $St_i$ does not affect the SM output **then**
5: Remove part or the totality of statement $St_i$.
6: **Mathmatical Inspection:**
7: **for** All Statements ($St_i$) **do**
8: Remove model parcels with multiplications by 0. e.g., if ($3 \times x + 0 \times y$>1): $\rightarrow$ if ($3 \times x$>1) :
9: Sum all zero-degree polynomials in each expression. e.g., if ($x + y$ - 3>1) : $\rightarrow$ if ($x + y$>4) :

---

As illustrated in Fig. 2, the model maintains complete interpretability throughout its evolution. This ensures that the operator can readily comprehend the dynamics and decisions of the model, even during the learning phases. Due to the *simplification,* the constant tuning process becomes faster as simpler models tend to have fewer constants, translating into a problem of smaller dimensions for the DE (*child*) to solve.

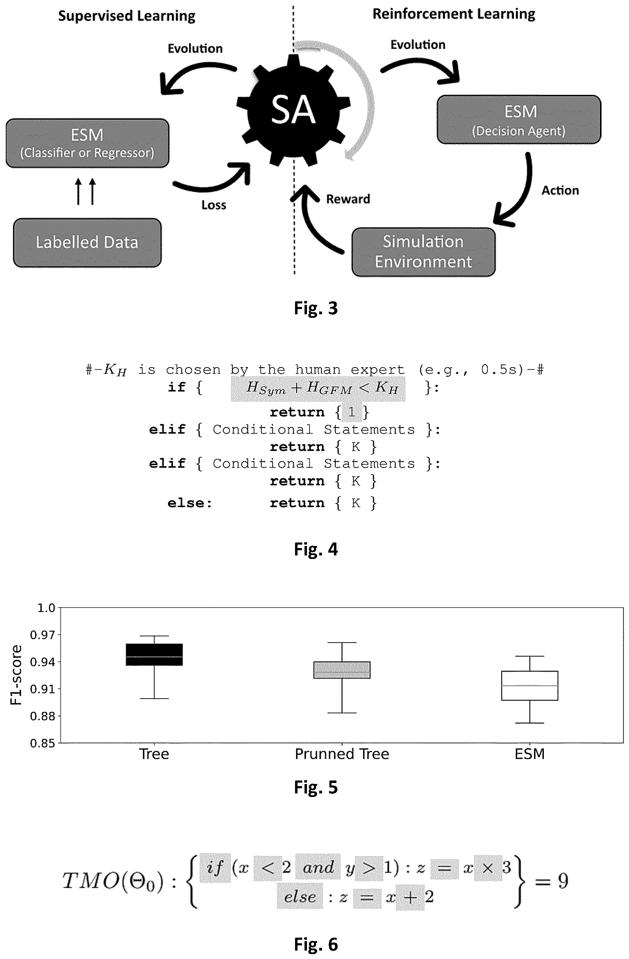

As illustrated in Fig. 3, the SA algorithm is used to guide the evolution of both i) the ESM-based classifier under a supervised learning setting by minimizing a loss function and ii) an ESM-based decision agent following an RL-based setting via trial-and-error interactions between the (simulation) environment and the decision agent aiming to maximise an environment-returned reward function.

**Figure 3** shows a schematic representation of an embodiment of an ESM evolution in supervised and reinforcement learning.

In an embodiment, adjustments to the ESM characteristics in the supervised and reinforcement learning, such as templates and representative domains, are aligned with the distinctive tasks executed by the model.

In an embodiment, the SA component is modified in the fitness function, which defines the ESM solution - either a loss or reward function. Recalibration of the SA's hyper-parameters, particularly the virtual Boltzmann constant ($K_b$), is required only when large differences in magnitude exist between the loss and reward functions.

In an embodiment, the RL approach herein disclosed does not construct value estimates of particular state-action pairs; instead, it reasons solely about the value of entire policies [29], [33], and it does so via the use of cumulative reward functions.

As a particular example the method herein disclosed was tested with Madeira Island's power system data. The Madeira Island power system comprises an isolated network operated at 30/60 kV, a diverse generation portfolio in 2024: hydro (77.17 MVA), thermal (295.74 MVA - only 15 MVA were considered for the dispatch), wind (70.11 MVA), solar (75 MVA), waste-to-energy - W2E (7.2 MVA), and a load changing between 60MW and 100 MW. To provide flexibility and support to the system's stability with high-RES share, the transmission system operator (TSO) relies on reversible hydro pumping stations and a 24 MVA (16 MWh) battery energy storage system (BESS). The share of RES is expected to grow, leading to challenging operating scenarios due to system stability concerns arising in zero thermal generation scenarios. Thus, the power system will be enhanced by installing another 24 MVA Battery Energy Storage System (BESS) and a 15 MVA synchronous condenser.

In an embodiment, the OP-characterizing variables comprise synchronous inertia of the power network, namely synchronous condensers and/or synchronous generators.

A dataset with 2095 unique operating scenarios (OS) was generated by sampling different combinations of load, share of synchronous generation and RES generation. This OS generation sought to find scenarios close to the system's security boundary while preserving sufficient coverage of the system's feasible region. For each scenario, the DigsILENT PowerFactory software performs a merit order unit commitment, power flow and dynamic simulation studies in a complete RMS model of the island network. After the stationary studies, an operating point (OP) is established, which is characterised by the pre-defined system variables listed in Table II. These pre-defined variables were engineered based on prior experience and expert knowledge, establishing a recognized correlation with the system's stability.

TABLE II: Pre-defined system variables for characterising an OP.

| Variable | Description |
|---|---|
| $Load$ | System Load |
| Pump | Hydro pumping |
| $H_{GFM}$ | System Virtual Inertia (if BESS is in GFM mode.) |
| $H_{Syrn}$ | System synchronous inertia |
| $Res_{noFRT}$ | RES without FRT capability |
| $Res_{GC}$ | RES that conform with the system grid code |
| $PV_{ZPM}$ | PV generation with a ZPM type response during fault |
| $Wind_{ZPM}$ | Wind generation with a ZPM type response during fault |

The results of the dynamic simulation study, which consists of the simulation of the three most severe short circuits to the system stability, are then integrated with the rules of Eq. 5. These rules compare the simulation-obtained values of two frequency stability indices with two protectionrelated threshold values, enabling a security classification for each *OP*. The rationale for using frequency metrics as criteria for security classification in the island of Madeira lies in the fact that security loss following severe events is mostly caused by large frequency swings that may trigger the system's load-shedding protections. The final composition of the generated dataset is 590 (28.2%) insecure OPs and 1505 (71.8%) secure OPs.

$$\Delta f_{Col} \geq 2 Hz$$

$$\Delta f_{Col} < 49 Hz \ \& \ Rocof_{Col}(250ms) < -2.5 Hz/s$$

(5)

Security Classification (SC), one of the DSA typical functions, is the task of classifying a system operating point as secure (0) or insecure (1). The ESM created to address this task is a rule-based classifier, whose *primitive model* includes a known stability condition based on the system's inertia to illustrate a cooperative initialisation in the DSA context.

Figure 4 shows a schematic representation of an embodiment of a primitive version of a classifier for Online Dynamic Security Classification, where the model template is highlighted in bold, and the operator knowledge contributions are highlighted in grey.

As an example, to obtain an evolved version of the above classifier, the algorithm 1 was used to maximise the classification F1-score of the ESM in the training dataset. Based on a sensitivity analysis, the following hyperparameters were used for the SA: $T_i$ (0.95), $T_f$ (0.05) and $Kb$ (70). Regarding the domain of symbols available for the construction/-mutation of the classifier, the one defined in Eq. 3 was adopted, with the particularity that the set of variables ($V_E$) consists of all the variables described in Table II. It is worth mentioning that despite all these variables being available throughout the ESM evolution, not all of them need to be present in the ESM final version. In fact, as shown in Fig. 2, the method has the ability to retain the most relevant variables.

Regarding the classification accuracy, to prove the method's ability to create models with good generalization capacity and remove its intrinsic randomness, the SA was run 20 times independently, and the F1-score in the test dataset was recorded. For each of the 20 runs, different seeds were consistently considered for the algorithm and the training/testing dataset partition. This same study was also conducted using standard and pruned versions of scikit-learn DTs, using minimal cost complexity as the pruning method.

**Figure 5** shows a graphical representation, in a boxplot, of a performance comparison of between tree, pruned tree and ESM classification methods. Herein is seen the distribution of the testset F1-score for each classification method. While unpruned DTs exhibit an accuracy advantage, the results show that ESMs can achieve comparable accuracy levels to pruned DTs. In fact, ESMs can even reach larger accuracy levels for some seeds.

Interpretability in this method refers to understanding a model's decision-making process, with global interpretability focusing on the overall behaviour and local interpretability targeting specific input sets [22]. Global interpretability in a model entails comprehending the principles governing its behaviour across all input ranges, requiring a thorough analysis of the entire model. This is influenced by the model's complexity, leading to increased mental effort during inspection. Consequently, the total number of mental operations, including the number of operations required to go from input to output, required to inspect the complete model (*TMO*) can be a metric for evaluating its global interpretability.

**Figure 6** show a schematic representation of an embodiment of a *TMO* computation for the model $\Theta_0$.

Note that the mental operations needed to follow all model decision paths, which are highlighted in grey, include not only arithmetic and logic operators but also every other type of operation that requires mental consideration, as is the case of the selection needed when interpreting "if" and "else".

When analysing the model's inner dynamics, the human expert does need to "read" the entire model since, for some of the inputs, a classification may be achieved through the action of the model. This model's characteristic is the local interpretability, which can still be measured using the number of mental operations. In this context, the focus is solely on the number of required mental operations ($RMO$) to trace the model's action path for each input.

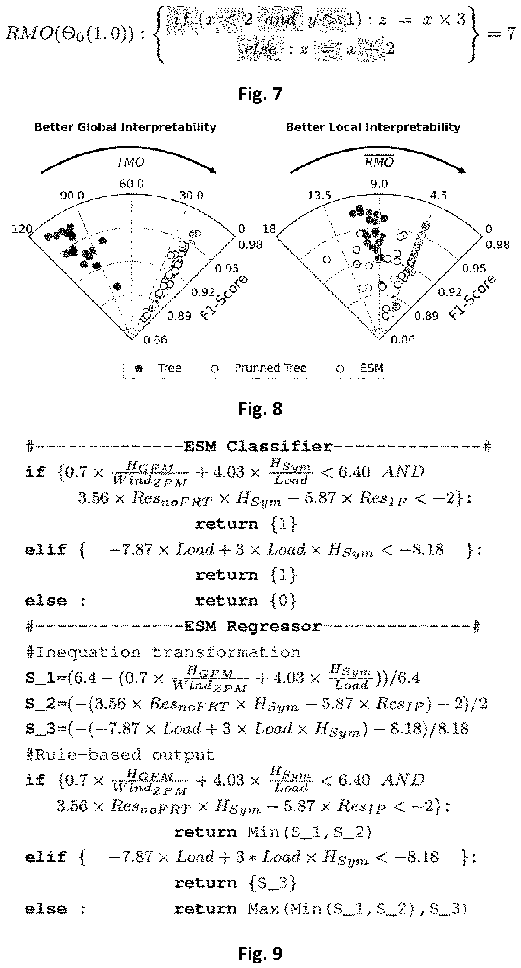

**Figure 7** shows a schematic representation of an embodiment of a RMO computation for the model $\Theta_0$, in view of the input (1,0).

Still, its use as a metric to compare the local interpretability of different models can rapidly become complex since each model will be characterized by multiple values (i.e., one per dataset instance). Thus, in an embodiment, the average RMO for all data-set inputs $\overline{RMO}$ is adopted to ease the model comparison process.

The two interpretability metrics, $TMO$ and $\overline{RMO}$, were used to score the interpretability of the models generated previously (DT, pruned DT, and ESM). The results obtained for these metrics are depicted in the radar charts of Fig. 8, $\overline{RMO}$ on the left and $TMO$ on the right.

**Figure 8** shows a graphical representation of the tree, pruned tree and ESM classification models interpretability.

Despite their high classification accuracy, DT show very low global interpretability, which is justified by the numerous tree nodes that allow for an intense space partition and, consequently, good accuracy, as they also represent large sequences of mental operations. If pruned, however, DT can display much better interpretability without a significant loss in classification accuracy, which puts them very close to the ESM. However, the ESM stand out as the model with the ability to achieve the lowest values in terms of $TMO$, evidencing a small edge in terms of global interpretability.

In the case of local interpretability, there is a smaller difference between the three methods; even so, it is clear that pruned trees are superior to the other methods. If a classification is achieved in the first nodes/conditions of the models, the number of required mental operations will tend to be higher for the ESM case since conditions are usually expressions (e.g., $3 \times Res_{noFRT} \times H_{Sym} - Res_{IP} < 2$) and not single variable inequations (e.g., $H_{sym} < 0.9$), as is the case for DTs. This architectural dichotomy explains the visible difference between trees and ESMs regarding the $\overline{RMO}$ values, which is more apparent in the pruned trees case. Still, it is worth mentioning that ESM's mathematical expressions enable non-linear partitions of the attribute space while preserving a compact nature that often evidences true physical relations.

The representative and interpretable nature of the ESM enables seamless direct model updates by the human expert (operator), a characteristic that can be explored not only for initialisation/mutation purposes during evolution, but also to augment the model so that different tasks can be performed.

This model ability, known as *reflection* in [32], is explored to transform the ESM classifier into a regressor, as this form provides additional information regarding the distance of a state ($OS_i$) to the system security boundary in the form of a security index ($S_i$).

In an embodiment, the method used to create an ESM classifier is used to generate the regressors directly. Still, this two-stage approach was undertaken to prove the *reflection* capacity that ESMs have.

To make this manipulation (i.e., from classifier to regressor), the output of the security classes (0-secure, 1-insecure) is replaced by the output of a security index (S), whose computation depends on the existing conditional statements. To achieve the security index expressions, the inequations of each conditional statement are manipulated until one of its sides is zero; the non-zero side is then used to determine the security index value when that specific condition is verified. The following example illustrates this manipulation:

Small Classifier:
*if* $(3 \times y < 1)$ : *return* 1; *else: return* 0;
Small Regressor:
*if* $(3 \times y < 1)$ : *return* 1 - 3 $\times$ *y*; *else*: *return* 1 - 3 $\times$ *y*;

Not that, after this manipulation, the regressor will output values larger than zero if the system is insecure and values lower than zero if it is secure. Hence, the regressor output of zero should be understood as the security boundary.

In an embodiment, the conditional statements include more than one inequality (e.g. *if* ($x < 1$ *AND* $y < 2$)). Hence, in these cases, assessing which inequality should be used to define the stability index expression is necessary. With that purpose, a min/max function is discussed previously to select the security index closer to the security boundary (one for each inequality). This transformation is illustrated as follows:

Small Classifier: *if* $(3 \times y < 9$ *AND* $2 \times x > 1)$ : *return* 1
Small Regressor:
$S_1 = 9 - 3 \times y; S_2 = 2 \times x - 1;$ *if* $(3 \times y < 9$ *AND* $2 \times x > 1)$: *Return* $Min(S_1, S_2)$

The above transformations were applied to one of the 20 ESM classifiers generated previously. In addition to the modification described earlier, each stability index expression was also normalized to the value of the threshold constant of the respective inequation to ensure a similar range of values for the stability index, regardless of the conditional statement that verifies. The resulting ESM regressor and the original classifier are depicted in Fig. 9.

**Figure 9** shows a schematic representation of a transformation of ESM classifier into a regressor.

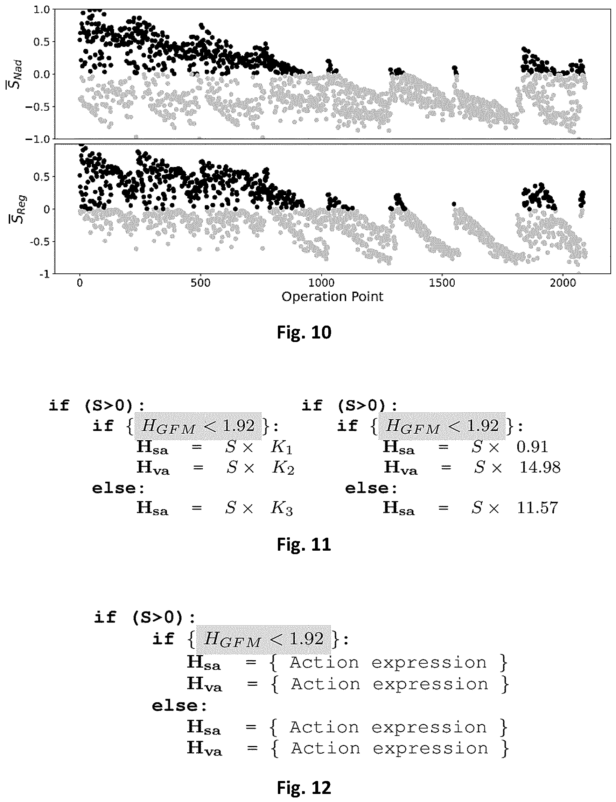

In an alternative embodiment, a stability indicator for the system is obtained by using dynamic simulation to obtain the stability indices described in Eq. 5. The distance of these indices from their limits (Eq. 5) can then be used as an indicator. In this case, the distance of the frequency Nadir from the limit value of 49 Hz ($S_{Nad}$ = 49 - $f_{Nad}$) is a suitable indicator, as this proved to be the determining condition among those in Eq. 5. Fig. 10 displays the normalised value of this Nadir-based stability indicator ($S_{Nad}$) and the normalised regressor output ($S_{Reg}$) for all points in the dataset.

**Figure 10** shows a graphical representation in scatter plots of the values of $S_{Nad}$ and $S_{Reg}$. Here the regressor output pattern is very similar to the nadir-based stability indicator computed with a dynamic simulation model of the Madeira Island power system. Hence, it can be concluded that using the manually created regressor to determine the degree of system stability is a good approximation of reality.

In an embodiment, when the operation point is classified as insecure or unstable, a human operator, or an automatically triggered rule via a threshold (e.g. defined by a human), requires a preventive control action that can mitigate system instability in the case of any disturbance. These control actions can be deduced from the classification rule designed under this approach. For the studied cases, this action entails deploying additional synchronous and/or virtual inertia ($H_{sa}$ and $H_{va}$) rather than a more classical approach, such as the generation re-dispatch. This choice is justified by the high share of low synchronous machine scenarios that make: 1) small *OP* changes inefficient from a security point of view and 2) significant *OP* changes costly due to the RES curtailment expenses.

1) *Reward function:* The synchronous inertia is dispatched via the different synchronous condensers (i.e., dedicated or generation units qualified for it), while the virtual inertia is dispatched by changing the control mode from grid-following to grid-forming in the BESS. Since the TSO plans to always have the BESS in operation (for stability support purposes) and no additional expenses result from a change in the battery control mode, the operational cost of a preventive control action is not dependent on the volume of additional virtual inertia. Conversely, the volume of synchronous inertia influences the cost of preventive control actions. In the case of dedicated synchronous condensers, there is a cost associated with the electricity needed to drive the motor; as for the hydro units, there is an additional cost and a preparation time related to the opening of the drainage valves located at the bottom of the turbine chamber to empty it from the water before it can be used as a synchronous condenser.

In an embodiment, the ESM for this task is trained under an RL-based approach, where the goal is to maximise the cumulative reward $R$ from Eq. 6. There, $R_i$ is the environment reward for an *OP i*, $K_H$ is the trade-off between the cost of additional synchronous inertia and the enhanced system security, and $S_i$ is the environment stability indicator for *OP i*.

$$R = \sum_{i=0}^{N_T} R_i = \sum_{i=0}^{N_T} (1 - 0.25(S_i + 1)^2 - H_{sa_i} \times K_H)$$

(6)

This reward function was chosen given its ability to represent two fundamental features of the problem, namely a) the non-linear relation between the need to improve further the system's security and the current security state ($S_i$), and b) the costs with dispatching additional synchronous inertia ($H_{sa}$). The feature (a) is captured by the behaviour of the reward function derivative ( $\frac{\partial R_i}{\partial S_i}$ ), whose form results in the provision of more significant rewards for improvements in unsecured zones ($S_i \gg 0$) where the agent action is much needed and poor rewards for improvements in zones already very secure ($S_i \ll 0$). The characteristic (b) is captured by using a trade-off function ($H_{sa_i} \times K_H$) that reflects how much additional synchronous inertia the operator is willing to dispatch to achieve a sufficient improvement in the system security. The trade-off value ($K_H$ = 0.15) was obtained by inquiring the TSO through an indifference judgment, as explained in [34].

Traditionally, the stability indicator (S) would be attained via time-domain simulation of the reference disturbances. However, this makes the RL procedure extremely heavy in terms of computation. Therefore, to make the procedure feasible, the ESM regressor of Fig. 9 is used as a surrogate model of the system behaviour.

**Figure 11** shows a schematic representation of an embodiment of a Human-ES agent, initial (to the left) vs. tunned with data (to the right).

*Benchmark models:* i) a simple SM, depicted in Fig. 11, designed by a human expert with its constants tuned by the DE method described previously. This model uses different proportional controllers according to the existing amount of virtual inertia ($H_{GFM}$). Dividing the agent actions based on the online virtual inertia allows for prioritizing the allocation of extra virtual inertia when capacity is available ($H_{GFM}$ < 1.92). ii) an ANN-based agent constructed using the RL framework based on evolutionary strategies from [29] - called RL-ANN. The ANN structure, 9x20x20x2 with sigmoid functions, was optimised with random search.

**Figure 12** shows a schematic representation of a primitive version of the ESM agent.

*Performance evaluation:* The *primitive model* of the ESM agent is depicted in Fig. 12. The ESM template is highlighted in bold, and the operator's initial contributions are highlighted in grey. The value of the additional synchronous or virtual inertia ($H_{sa}/H_{va}$) suggested by the agent is always subjected to a saturation block to ensure that this inertia volume exists in the system (i.e., *Hsa = clip(Hsa,Hsa$_{Min}$,Hsa$_{Max}$)*).

The RL was executed 20 times, with varying seeds and partitions of the train/test datasets. Three metrics were computed for the test dataset:

$R_{Test}$, the reward function value in the testing dataset;

$H_{add}$, the additional volume of synchronous inertia dispatched by the ESM agent, i.e., $H_{add} = \sum_{i=0}^{N_{Test}} Hsa_i$;

$S_{worst}$, the highest value of the stability indicator that can still be found when the ESM agent action is considered, i.e., $S_{worst}= Max(S_i) \; \forall i \in \{Test\ Indices\}$.

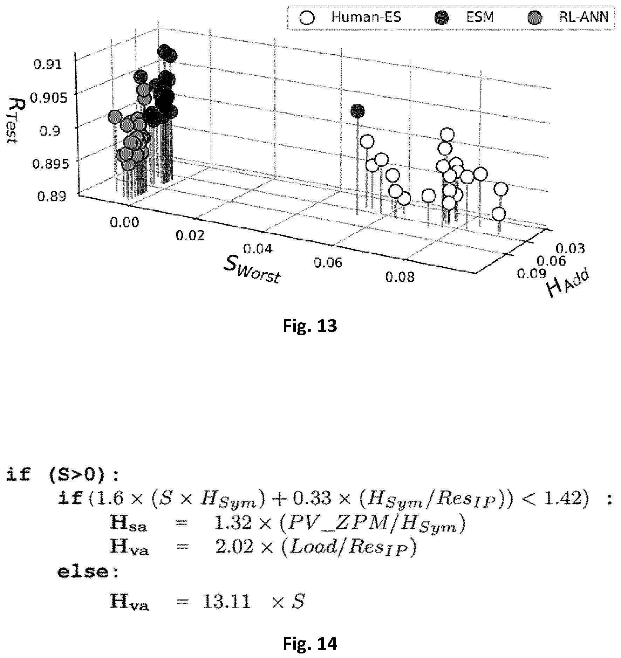

**Figure 13** shows a graphical representation of the performance of ESM vs. Human-ES and RL-ANN (benchmark models) using the values of $R_{Test}$, $H_{add}$, $S_{worst}$ across each of the 20 runs, computed for each model. This plot shows, once more, the ability of ESMs to successfully adapt to different tasks.

As can be seen, the ESM agent consistently maintained security across the entire spectrum of the testing set operating points ($S_{Worst}< 0$), a characteristic not observed in the case of the Human-ES agent. This enhancement in security directly influenced the reward, showing that the agent did not over dispatch the volume of synchronous inertia to ensure security.

**Figure 14** shows a schematic representation of a final version of the RL ESM agent. Here it can be seen that the ESMs retain full interpretability and compact nature, showcasing one of the resulting ESMs.

Conversely, the ANN-based agents showed very limited interpretability, with an average $\overline{RMO}$ and *TMO* of 1282 in comparison to the 12.9 and 18.6 values that characterize the ESM collection and a performance that is slightly worse than what the ESMs can achieve.

This document discloses a novel data-driven method to construct inherently interpretable models for DSA, using data from the isolated power system of Madeira Island as the proof-of-concept case study.

The ESM model, developed for the security classification task, showed classification accuracy comparable to pruned DT and better global interpretability. The ESMs also thoroughly outperformed the unpruned DTs regarding global interpretability, albeit with a marginal reduction in classification accuracy. The nature of the ESM mathematical expression offers a relevant potential in terms of new knowledge creation and *reflection* capacity. For instance, the ESM classifier demonstrates versatility by transforming seamlessly into a regressor without requiring retraining. In terms of preventive actions, it showed high skill in restoring the system security without over-dispatching inertia, outperforming an ANN and a human-designed expert system that responds proportionally to the stability indicator. Importantly, the interpretability and compact nature of the ESM-based decision agent aligns well with the regulatory requirements for high-risk sectors in the European Union AI Act.

It is to be appreciated that certain embodiments of the disclosure as described herein may be incorporated as code (e.g., a software algorithm or program) residing in firmware and/or on computer useable medium having control logic for enabling execution on a computer system having a computer processor, such as any of the servers described herein. Such a computer system typically includes memory storage configured to provide output from execution of the code which configures a processor in accordance with the execution. The present disclosure is also particularly apt for execution on a GPU -graphics processing unit (a specialized processor explicitly designed for executing graphical algorithms), NPU - neural processing unit (a specialized processor explicitly designed for executing machine learning algorithms), or any other inherently parallel processing unit. For example, models were run on Linux PC with Intel Xeon CPU cores and a NVIDIA GeForce RTX. The code can be arranged as firmware or software, and can be organized as a set of modules, including the various modules and algorithms described herein, such as discrete code modules, function calls, procedure calls or objects in an object-oriented programming environment. If implemented using modules, the code can comprise a single module or a plurality of modules that operate in cooperation with one another to configure the machine in which it is executed to perform the associated functions, as described herein.

The term "comprising" whenever used in this document is intended to indicate the presence of stated features, integers, steps, components, but not to preclude the presence or addition of one or more other features, integers, steps, components, or groups thereof.

The disclosure should not be seen in any way restricted to the embodiments described and a person with ordinary skill in the art will foresee many possibilities to modifications thereof. The above-described embodiments are combinable. The following claims further set out particular embodiments of the disclosure.

The research leading to this work is being carried out as a part of the ENFIELD (European Lighthouse to Manifest Trustworthy and Green AI) project, European Union's Horizon Research and Innovation Programme, Grant Agreement No. 101120657. Views and opinions expressed are, however, those of the author(s) only and do not necessarily reflect those of the European Union. Neither the European Union nor the granting authority can be held responsible for them.

This work is co-financed by Component 5 - Capitalization and Business Innovation of core funding for Technology and Innovation Centres (CTI), integrated in the Resilience Dimension of the Recovery and Resilience Plan within the scope of the Recovery and Resilience Mechanism (MRR) of the European Union (EU), framed in the Next Generation EU, for the period 2021 - 2026.

## REFERENCES

[1] A. Marot, A. Kelly, M. Naglic, V. Barbesant, J. Cremer, A. Stefanov, and J. Viebahn, "Perspectives on future power system control centers for energy transition," J. of Mod. Pow. Sys. and Clean Ener., vol. 10, no. 2, pp. 328-344, Mar. 2022.

[2] L. Wehenkel, "Machine learning approaches to power-system security assessment," IEEE Expert, vol. 12, no. 5, pp. 60-72, Sep. 1997.

[3] Z. Zhang, G. S. Hope, and O. P. Malik, "Expert systems in electric power systems-a bibliographical survey," IEEE Trans. on Pow. Sys., vol. 4, no. 4, pp. 1355-1362, Nov. 1989.

[4] R. Christie and S. Talukdar, "Expert systems for on line security assessment-a preliminary design," IEEE Trans. on Pow. Sys., vol. 3, no. 2, pp. 654-659, May 1988.

[5] B. Jeyasurya and S. S. Venkata, "A knowledge-based approach for power system dynamic security assessment," in Proc. of the 3rd Int. Conf. on Ind. and Eng. App. of Art. Int. and Expert Sys., 1990, p. 645-652.

[6] P. Dash, S. Mishra, M. Salama, and A. Liew, "Classification of power system disturbances using a fuzzy expert system and a Fourier linear combiner," IEEE Trans. on Pow. Del., vol. 15, no. 2, pp. 472-477, 2000.

[7] D. Sobajic and Y.-H. Pao, "Artificial neural-net based dynamic security assessment for electric power systems," IEEE Trans. on Pow. Sys., vol. 4, no. 1, pp. 220-228, Feb. 1989.

[8] A. Gupta, G. Gurrala, and P. S. Sastry, "An online power system stability monitoring system using convolutional neural networks," IEEE Trans. on Pow. Sys., vol. 34, no. 2, pp. 864-872, Mar. 2019.

[9] J. Huang, L.Guan, Y.Su, H.Yao, M.Guo, and Z.Zhong, "Recurrent graph convolutional networkbased multi-task transient stability assessment framework in power system," IEEE Access, vol.8 93283-93296, 2020.

[10] A. Mehrzad, M. Darmiani, Y. Mousavi, M. Shafie-Khah, and M. Aghamohammadi, "A review on data-driven security assessment of power systems: Trends and applications of artificial intelligence," IEEE Access, vol. 11, pp. 78671-78685, 2023.

[11] R. Liu, G. Verbic, and J. Ma, "A new dynamic security assessment˘ framework based on semisupervised learning and data editing," Elect. Pow. Sys. Res., vol. 172, pp. 221-229, Jul. 2019.

[12] R. Sousa, C. Moreira, L. Carvalho, and M. Matos, "Including dynamic security constraints in isolated power systems unit commitment/economic dispatch: a machine learning-based approach," in 2023 IEEE Belgrade Power-Tech, Jun. 2023.

[13] J. Fidalgo, J. Pecas Lopes, and V. Miranda, "Neural networks applied to preventive control measures for the dynamic security of isolated power systems with renewables," IEEE Trans. on Pow. Sys., vol. 11, no. 4, pp. 1811-1816, Nov. 1996.

[14] C. Rudin, "Stop explaining black box machine learning models for high stakes decisions and use interpretable models instead," Nature Machine Intelligence, vol. 1, no. 5, pp. 206-215, May 2019.

[15] L. Wehenkel, T. V. Cutsem, and M. Ribbens-Pavella, "Decision trees applied to on-line transient stability assessment of power systems," 1988 IEEE Int. Sym. on Circuits and Sys., Jun. 1988.

[16] C. Liu, K. Sun, Z. H. Rather, Z. Chen, C. L. Bak, P. Thøgersen, and P. Lund, "A systematic approach for dynamic security assessment and the corresponding preventive control scheme based on decision trees," IEEE Trans. on Pow. Sys., vol. 29, no. 2, pp. 717-730, Mar. 2014.

[17] M. Lashgari and S. M. Shahrtash, "Fast online decision tree-based scheme for predicting transient and short-term voltage stability status and determining driving force of instability," Int. J. of Elect. Pow. & Ener. Sys., vol. 137, p. 107738, May 2022.

[18] J. L. Cremer, I. Konstantelos, and G. Strbac, "From optimization-based machine learning to interpretable security rules for operation," IEEE Trans. on Pow. Sys., vol. 34, no. 5, pp. 3826-3836, Sep. 2019.

[19] I. Gene, R. Diao, V. Vittal, S. Kolluri, and S. Mandal, "Decision treebased preventive and corrective control applications for dynamic security enhancement in power systems," IEEETrans. on Pow. Sys., vol. 25, no. 3, pp. 1611-1619, Aug. 2010.

[20] E. Karapidakis and N. Hatziargyriou, "Online preventive dynamic security of isolated power systems using decision trees," IEEE Trans. on Pow. Sys., vol. 17, no. 2, pp. 297-304, 2002.

[21] J. R. Quinlan, "Simplifying decision trees," Int. J. Man Mach. Stud., vol. 27, pp. 221-234, 1987.

[22] D. Slack, S. A. Friedler, C. Scheidegger, and C. D. Roy, "Assessing the local interpretability of machine learning models," in 33rd Conf. on Neural Infor. Proc. Sys. (NeurIPS 2019), Vancouver, Canada, Dec. 2019.

[23] A.-A. B. Bugaje, J. L. Cremer, M. Sun, and G. Strbac, "Selecting decision trees for power system security assessment," Energy and AI, vol. 6, p. 100110, Dec. 2021.

[24] D. T. Lagos and N. D. Hatziargyriou, "Data-driven frequency dynamic unit commitment for island systems with high RES penetration," IEEE Trans. on Pow. Sys., vol. 36, no. 5, pp. 4699-4711, Sep. 2021.

[25] R. I. Hamilton and P. N. Papadopoulos, "Using SHAP values and machine learning to understand trends in the transient stability limit," IEEE Trans. on Pow. Sys., vol. 39, no. 1, pp. 1384-1397, Jan. 2024.

[26] C. Ren, Y. Xu, and R. Zhang, "An interpretable deep learning method for power system transient stability assessment via tree regularization," IEEE Trans. on Pow. Sys., vol. 37, no. 5, pp. 3359-3369, Sep. 2022.

[27] E. Real, C. Liang, D. R. So, and Q. V. Le, "AutoML-Zero: Evolving machine learning algorithms from scratch," in 37th Inter. Conf. on Machine Learning, vol. 119, 2020.

[28] C. J. Belisle, "Convergence theorems for a class of simulated annealing' algorithms on Rd," J. of App. Prob., vol. 29, no. 4, pp. 885-895, 1992.

[29] T. Salimans, J. Ho, X. Chen, and I. Sutskever, "Evolution strategies as a scalable alternative to reinforcement learning," arXiv:1703.03864, 2017.

[30] S. Chaudhuri, K. Ellis, O. Polozov, R. Singh, A. Solar-Lezama, and Y. Yue, "Neuro programming," in Tutorial at Neural Information Processing Systems (NeurIPS), Nova Orleans, Luisiana, US, 2022.

[31] J. R. Koza, Genetic Programming. On the Programming of Computers by Means of Natural Selection. Cambridge, USA: MIT Press, 1992.

[32] J. Swan, E. Nivel, N. Kant, J. Hedges, T. Atkinson, and B. Steunebrink, The Road to General Intelligence, J. Kacprzyk, Ed. Cham, Switzerland: Springer, 2022.

[33] S. Whiteson, Reinforcement Learning State-of-the-Art. Springer, 2012, ch. Evolutionary Computation for Reinforcement Learning, pp. 325-355.

[34] V. Chankong and Y. Y. Haimes, Multiobjective Decision Making: Theory and Methodology. New York, USA: Courier Dover Publications, 2008.

## Claims

1. A computer-implemented method for dynamic security assessment of stability of an electrical power system, comprising:

    receiving input data comprising a training dataset comprising training data records, each training data record corresponding to an operating point, OP, of an operating scenario of the power system and comprising a set of OP-characterizing variables and a stability classification for the characterized OP;
    receiving a template model as a current model of the power system stability, wherein a model comprises one or more conditional statements (if), each conditional statement comprising one or more logical expressions (a>2.1), each logical expression comprising one or more logical operators (OR, AND), zero or more numerical constants (2.1), zero or more weighted OP-characterizing variables (a), wherein each conditional statement returns a stability classification of stable or unstable (return 1);
    setting a temperature variable with an initial temperature from a predetermined cooling scheme; and
    repeating the following steps until the temperature variable reaches a final temperature from the predetermined cooling scheme:

        selecting a mutation from a mutation database comprising a plurality of mutations, wherein
        each mutation comprises a change instruction of addition, removal, or replacement of a logical expression, a logical operator, a logical constant and/or a variable;
        applying the selected mutation to the current model for obtaining a neighbour model;
        evaluating a fitness function of the current and neighbour models;
        if the fitness of the neighbour model is improved relative to the fitness of the current model,
        or if a random number between 0 and 1 is lower than a probability of adopting the mutation,
        then updating the current model to be the neighbour model; and
        adjusting the temperature variable according to the predetermined cooling scheme.

2. The method according to the previous claim further comprising a step of outputting the current model as the model for dynamic security assessment of stability of a power system.

3. The method according to any of the previous claims, for providing a dynamic security assessment of stability of a power system using said model, comprising:

receiving input data comprising an operational data record comprising OP-characterizing variables of the power system OP;

applying the model to the OP-characterizing variables to obtain a stability classification or a security index.

4. The method according to the previous claim, comprising continuously assessing stability of the power system by:

continuously receiving input data comprising an operational data record comprising OP-characterizing variables of the power system OP;

continuously applying the model to the OP-characterizing variables to obtain a security classification or a security index.

5. The method according to the previous claim, comprising generating real-time alerts; and, outputting the generated alerts, in particular comprising triggering automated corrective actions within the power system according to the generated real-time alerts.

6. The method according to any of the previous claims wherein the probability is also a function of the temperature variable.

7. The method according to any of the previous claims wherein the probability is also a function of the difference between fitness of the current model and the fitness of the neighbour model.

8. The method according to any of the previous claims wherein the change instruction, and the logical expression, logical operator, logical constant and/or variable to be of added, removed, or replaced, are represented by a binary token, in particular a bytecode token.

9. The method according to any of the previous claims wherein the initial model is a predetermined model received from an external source.

10. The method according to any of the previous claims wherein each repetition of the repeating steps comprises removing variables with zeroed weight in the current model; and/or sum numerical constants in each logical expression.

11. The method according to any of the previous claims wherein the probability is also a function of the temperature variable weighed by a tuneable Boltzmann constant, Kb, and initial, $T_0$, and final, $T_f$, temperatures of the cooling scheme.

12. The method according to any of the previous claims, wherein the model includes variables related to both steady-state and transient conditions of the power system, in particular the OP-characterizing variables comprise a synchronous-inertia variable and/or a battery energy storage variable of the power system.

13. The method according to any of the previous claims, wherein the repeating steps are performed in parallel.

14. A system comprising a processor configured to carry out the method of any of the previous claims.

15. A computer program product embodied in a non-transitory computer readable medium and comprising computer instructions which when executed by a computer, cause the computer to carry out the method of any of the claims 1-13.

if { Conditional Statements } :
{ Sequence of Action } **elif** { Conditional Statements }:
{ Sequence of Action } **else**: { Sequence of Action }

**Fig. 1**

**Fig. 2**

**Fig. 3**

```
#-K_H is chosen by the human expert (e.g., 0.5s)-#
        if {      H_Sym + H_GFM < K_H   }:
                    return { 1 }
    elif { Conditional Statements }:
                    return { K }
    elif { Conditional Statements }:
                    return { K }
        else:       return { K }
```

**Fig. 4**

**Fig. 5**

$$TMO(\Theta_0) : \left\{ \begin{array}{l} if\ (x < 2\ and\ y > 1) : z = x \times 3 \\ else\ : z = x + 2 \end{array} \right\} = 9$$

**Fig. 6**

$$RMO(\Theta_0(1,0)) : \left\{ \begin{array}{c} if\ (x < 2\ and\ y > 1) : z = x \times 3 \\ else\ : z = x + 2 \end{array} \right\} = 7$$

**Fig. 7**

**Better Global Interpretability**     **Better Local Interpretability**

TMO     $\overline{RMO}$

| ● Tree | ◎ Prunned Tree | ○ ESM |

**Fig. 8**

```
#--------------ESM Classifier--------------#
if {0.7 × H_GFM/Wind_ZPM + 4.03 × H_Sym/Load < 6.40  AND
        3.56 × Res_noFRT × H_Sym − 5.87 × Res_IP < −2}:
                    return {1}
elif {   −7.87 × Load + 3 × Load × H_Sym < −8.18   }:
                    return {1}
else :              return {0}
#--------------ESM Regressor--------------#
#Inequation transformation
S_1=(6.4 − (0.7 × H_GFM/Wind_ZPM + 4.03 × H_Sym/Load ))/6.4
S_2=(−(3.56 × Res_noFRT × H_Sym − 5.87 × Res_IP) − 2)/2
S_3=(−(−7.87 × Load + 3 × Load × H_Sym) − 8.18)/8.18
#Rule-based output
if {0.7 × H_GFM/Wind_ZPM + 4.03 × H_Sym/Load < 6.40  AND
        3.56 × Res_noFRT × H_Sym − 5.87 × Res_IP < −2}:
                    return Min(S_1,S_2)
elif {   −7.87 × Load + 3 * Load × H_Sym < −8.18   }:
                    return {S_3}
else :              return Max(Min(S_1,S_2),S_3)
```

**Fig. 9**

Fig. 10

```
if (S>0):                    if (S>0):
    if { HGFM < 1.92 }:          if { HGFM < 1.92 }:
        Hsa   =  S × K1             Hsa   =  S × 0.91
        Hva   =  S × K2             Hva   =  S × 14.98
    else:                        else:
        Hsa   =  S × K3             Hsa   =  S × 11.57
```

Fig. 11

```
if (S>0):
    if { HGFM < 1.92 }:
        Hsa   = { Action expression }
        Hva   = { Action expression }
    else:
        Hsa   = { Action expression }
        Hva   = { Action expression }
```

Fig. 12

**Fig. 13**

```
if (S>0):
    if (1.6 × (S × H_Sym) + 0.33 × (H_Sym/Res_IP)) < 1.42) :
        H_sa  =  1.32 × (PV_ZPM/H_Sym)
        H_va  =  2.02 × (Load/Res_IP)
    else:
        H_va  = 13.11  × S
```

**Fig. 14**

Europäisches
Patentamt
European
Patent Office
Office européen
des brevets

# EUROPEAN SEARCH REPORT

**Application Number**

EP 25 15 5896

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| T | EP 2 978 095 A1 (ABB TECHNOLOGY AG [CH]) 27 January 2016 (2016-01-27) * Section "Selecting the parameters" * ----- | | **INV.** G05B17/02 G06F30/27 G06N3/126 G06Q50/06 H02J3/00 |
| X | Anonymous: "Simulated annealing – Wikipedia", , 29 August 2014 (2014-08-29), XP055431093, Retrieved from the Internet: URL:https://en.wikipedia.org/w/index.php?title=Simulated_annealing&oldid=623305668 [retrieved on 2017-12-01] * paragraph [0010] - paragraph [0037] * ----- | 1-15 | |
| A | ALIMI OYENIYI AKEEM ET AL: "A Review of Machine Learning Approaches to Power System Security and Stability", IEEE ACCESS, IEEE, USA, vol. 8, 18 June 2020 (2020-06-18), pages 113512-113531, XP011795792, DOI: 10.1109/ACCESS.2020.3003568 [retrieved on 2020-06-25] * Section IV * ----- | 1-15 | |
| | | | **TECHNICAL FIELDS SEARCHED (IPC)** G05B G06N G06Q G06F H02J |

The present search report has been drawn up for all claims

| Place of search | Date of completion of the search | Examiner |
|---|---|---|
| Munich | 28 August 2025 | Chabas, Julien |

EPO FORM 1503 03.82 (P04C01)

## ANNEX TO THE EUROPEAN SEARCH REPORT
## ON EUROPEAN PATENT APPLICATION NO.

EP 25 15 5896

This annex lists the patent family members relating to the patent documents cited in the above-mentioned European search report.
The members are as contained in the European Patent Office EDP file on
The European Patent Office is in no way liable for these particulars which are merely given for the purpose of information.

28-08-2025

| Patent document cited in search report | Publication date | Patent family member(s) | Publication date |
|---|---|---|---|
| EP 2978095 A1 | 27-01-2016 | NONE | |

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **A. MAROT** ; **A. KELLY** ; **M. NAGLIC** ; **V. BARBE-SANT** ; **J. CREMER** ; **A. STEFANOV** ; **J. VIEBAHN**. Perspectives on future power system control centers for energy transition. *J. of Mod. Pow. Sys. and Clean Ener.*, March 2022, vol. 10 (2), 328-344
- **L. WEHENKEL**. Machine learning approaches to power-system security assessment. *IEEE Expert*, September 1997, vol. 12 (5), 60-72
- **Z. ZHANG** ; **G. S. HOPE** ; **O. P. MALIK**. Expert systems in electric power systems-a bibliographical survey. *IEEE Trans. on Pow. Sys.*, November 1989, vol. 4 (4), 1355-1362
- **R. CHRISTIE** ; **S. TALUKDAR**. Expert systems for on line security assessment-a preliminary design. *IEEE Trans. on Pow. Sys.*, May 1988, vol. 3 (2), 654-659
- **B. JEYASURYA** ; **S. S. VENKATA**. A knowledge-based approach for power system dynamic security assessment. *Proc. of the 3rd Int. Conf. on Ind. and Eng. App. of Art. Int. and Expert Sys.*, 1990, 645-652
- **P. DASH** ; **S. MISHRA** ; **M. SALAMA** ; **A. LIEW**. Classification of power system disturbances using a fuzzy expert system and a Fourier linear combiner. *IEEE Trans. on Pow. Del.*, 2000, vol. 15 (2), 472-477
- **D. SOBAJIC** ; **Y.-H. PAO**. Artificial neural-net based dynamic security assessment for electric power systems. *IEEE Trans. on Pow. Sys.*, February 1989, vol. 4 (1), 220-228
- **A. GUPTA** ; **G. GURRALA** ; **P. S. SASTRY**. An online power system stability monitoring system using convolutional neural networks. *IEEE Trans. on Pow. Sys*, March 2019, vol. 34 (2), 864-872
- **J. HUANG** ; **L.GUAN** ; **Y.SU** ; **H.YAO** ; **M.GUO** ; **Z.ZHONG**. Recurrent graph convolutional network-based multi-task transient stability assessment framework in power system. *IEEE Access*, 2020, vol. 8, 93283-93296
- **A. MEHRZAD** ; **M. DARMIANI** ; **Y. MOUSAVI** ; **M. SHAFIE-KHAH** ; **M. AGHAMOHAMMADI**. A review on data-driven security assessment of power systems: Trends and applications of artificial intelligence. *IEEE Access*, 2023, vol. 11, 78671-78685
- **R. SOUSA** ; **C. MOREIRA** ; **L. CARVALHO** ; **M. MATOS**. Including dynamic security constraints in isolated power systems unit commitment/economic dispatch: a machine learning-based approach. *2023 IEEE Belgrade PowerTech*, June 2023
- **J. FIDALGO** ; **J. PECAS LOPES** ; **V. MIRANDA**. Neural networks applied to preventive control measures for the dynamic security of isolated power systems with renewables. *IEEE Trans. on Pow. Sys*, November 1996, vol. 11 (4), 1811-1816
- **C. RUDIN**. Stop explaining black box machine learning models for high stakes decisions and use interpretable models instead. *Nature Machine Intelligence*, May 2019, vol. 1 (5), 206-215
- **L. WEHENKEL** ; **T. V. CUTSEM** ; **M. RIBBENS-PAVELLA**. Decision trees applied to on-line transient stability assessment of power systems. *1988 IEEE Int. Sym. on Circuits and Sys*, June 1988
- **C. LIU** ; **K. SUN** ; **Z. H. RATHER** ; **Z. CHEN** ; **C. L. BAK** ; **P. THØGERSEN** ; **P. LUND**. A systematic approach for dynamic security assessment and the corresponding preventive control scheme based on decision trees. *IEEE Trans. on Pow. Sys*, March 2014, vol. 29 (2), 717-730
- **M. LASHGARI** ; **S. M. SHAHRTASH**. Fast online decision tree-based scheme for predicting transient and short-term voltage stability status and determining driving force of instability. *Int. J. of Elect. Pow. & Ener. Sys.*, May 2022, vol. 137, 107738
- From optimization-based machine learning to interpretable security rules for operation. **J. L. CREMER** ; **I. KONSTANTELOS** ; **G. STRBAC**. Trans. on Pow. Sys.. IEEE, September 2019, vol. 34, 3826-3836
- Decision treebased preventive and corrective control applications for dynamic security enhancement in power systems. **I. GENE** ; **R. DIAO** ; **V. VITTAL** ; **S. KOLLURI** ; **S. MANDAL**. Trans. on Pow. Sys.. IEEE, August 2010, vol. 25, 1611-1619
- Online preventive dynamic security of isolated power systems using decision trees. **E. KARAPIDAKIS** ; **N. HATZIARGYRIOU**. Trans. on Pow. Sys.. IEEE, 2002, vol. 17, 297-304
- **J. R. QUINLAN**. Simplifying decision trees. *Int. J. Man Mach. Stud.*, 1987, vol. 27, 221-234
- **D. SLACK** ; **S. A. FRIEDLER** ; **C. SCHEIDEGGER** ; **C. D. ROY**. Assessing the local interpretability of machine learning models. *33rd Conf. on Neural Infor. Proc. Sys. (NeurIPS 2019)*, December 2019
- **A.-A. B. BUGAJE** ; **J. L. CREMER** ; **M. SUN** ; **G. STRBAC**. Selecting decision trees for power system security assessment. *Energy and AI*, December 2021, vol. 6, 100110

- Data-driven frequency dynamic unit commitment for island systems with high RES penetration. **D. T. LAGOS** ; **N. D. HATZIARGYRIOU**. Trans. on Pow. Sys.. IEEE, September 2021, vol. 36, 4699-4711
- Using SHAP values and machine learning to understand trends in the transient stability limit. **R. I. HAMILTON** ; **P. N. PAPADOPOULOS**. Trans. on Pow. Sys.. IEEE, January 2024, vol. 39, 1384-1397
- An interpretable deep learning method for power system transient stability assessment via tree regularization. **C. REN** ; **Y. XU** ; **R. ZHANG**. Trans. on Pow. Sys. IEEE, September 2022, vol. 37, 3359-3369
- **E. REAL** ; **C. LIANG** ; **D. R. SO** ; **Q. V. LE**. AutoML-Zero: Evolving machine learning algorithms from scratch. *37th Inter. Conf. on Machine Learning*, 2020, vol. 119
- **C. J. BELISLE**. Convergence theorems for a class of simulated annealing' algorithms on Rd. *J. of App. Prob.*, 1992, vol. 29 (4), 885-895
- **T. SALIMANS** ; **J. HO** ; **X. CHEN** ; **I. SUTSKEVER**. Evolution strategies as a scalable alternative to reinforcement learning. *arXiv:1703.03864*, 2017
- **S. CHAUDHURI** ; **K. ELLIS** ; **O. POLOZOV** ; **R. SINGH** ; **A. SOLAR-LEZAMA** ; **Y. YUE**. Neuro programming. *Tutorial at Neural Information Processing Systems (NeurIPS)*, 2022
- **J. R. KOZA**. Genetic Programming. On the Programming of Computers by Means of Natural Selection. MIT Press, 1992
- **J. SWAN** ; **E. NIVEL** ; **N. KANT** ; **J. HEDGES** ; **T. ATKINSON** ; **B. STEUNEBRINK**. The Road to General Intelligence. Springer, 2022
- Evolutionary Computation for Reinforcement Learning. **S. WHITESON**. Reinforcement Learning State-of-the-Art.. Springer, 2012, 325-355
- **V. CHANKONG** ; **Y. Y. HAIMES**. Multiobjective Decision Making: Theory and Methodology.. Courier Dover Publications, 2008